# EUROPÄISCHE PATENTSCHRIFT

(11) **EP 3 559 710 B1**
(45) Veröffentlichungstag und Bekanntmachung des Hinweises auf die Patenterteilung: **19.07.2023**
(21) Anmeldenummer: 17821900.2
(22) Anmeldetag: 20.12.2017
(51) Int. Cl.: G02B 1/11, G02B 1/118

(54) **VERFAHREN ZUR HERSTELLUNG EINES REFLEXIONSMINDERNDEN SCHICHTSYSTEMS**
METHOD FOR PRODUCING A REFLECTION-REDUCING LAYER SYSTEM
PROCÉDÉ DE PRODUCTION D'UN SYSTÈME STRATIFIÉ ANTIRÉFLÉCHISSANT

(30) Priorität: 21.12.2016 DE 102016125197
(43) Veröffentlichungstag der Anmeldung: 30.10.2019
(73) Patentinhaber: Fraunhofer-Gesellschaft zur Förderung der angewandten Forschung e.V., 80686 München (DE)
(72) Erfinder: SCHULZ, Ulrike, 07745 Jena (DE); MUNZERT, Peter, 07745 Jena (DE); WOLLEB, Sabrina, 07745 Jena (DE); RICKELT, Friedrich, 07745 Jena (DE); KNOPF, Heiko, 07745 Jena (DE)
(74) Vertreter: Epping - Hermann - Fischer
(86) Internationale Anmeldenummer: PCT/EP2017/083867
(87) Internationale Veröffentlichungsnummer: WO 2018/115149

(56) Entgegenhaltungen:
- EP-A1- 2 966 481
- EP-A1- 3 051 321
- DE-A1- 10 241 708
- DE-A1-102007 009 512
- DE-A1-102007 059 886
- DE-A1-102008 018 866
- DE-A1-102014 100 769
- DE-B3-102015 203 307
- DE-B4-102014 100 769

## Beschreibung

Die Erfindung betrifft ein Verfahren zur Herstellung eines reflexionsmindernden Schichtsystems auf einem Substrat, insbesondere auf einem Glas- oder Kunststoffsubstrat für optische Anwendungen.

Zur Entspiegelung von Oberflächen, insbesondere von optischen Elementen oder Displays, werden üblicherweise reflexionsmindernde Interferenzschichtsysteme verwendet, die mehrere alternierende Schichten aus hochbrechenden und niedrigbrechenden Materialien enthalten. Als Material mit einer besonders niedrigen Brechzahl im sichtbaren Spektralbereich wird derzeit MgF₂ mit n = 1,38 eingesetzt. Die Entspiegelungswirkung herkömmlicher dielektrischer Schichtsysteme könnte verbessert werden, wenn Materialien mit geringerer Brechzahl zur Verfügung stehen würden.

Eine alternative Möglichkeit zur Verminderung der Reflexion eines optischen Elements ist aus der Patentschrift DE 10241708 B4 bekannt. Bei diesem Verfahren wird an der Oberfläche eines Kunststoffsubstrats mittels eines Plasmaätzprozesses eine Nanostruktur erzeugt, durch die die Reflexion des Kunststoffsubstrats vermindert wird. Die Entspiegelung eines optischen Elements durch die Erzeugung einer Nanostruktur an dessen Oberfläche hat den Vorteil, dass eine geringe Reflexion über einen weiten Einfallswinkelbereich erzielt wird.

Die Druckschrift DE 102008018866 A1 beschreibt ein reflexionsminderndes Interferenzschichtsystem, auf das eine organische Schicht aufgebracht wird, die mittels eines Plasmaätzprozesses mit einer Nanostruktur versehen wird.

Die Druckschrift DE 10 2007 059 886 A1 betrifft ein Verfahren zur Herstellung einer reflexionsmindernden Schicht.

In der Druckschrift EP 2 966 481 A1 ist ein Verfahren zur Herstellung einer Entspiegelungsschicht auf einer Silikonoberfläche angegeben.

Der Erfindung liegt die Aufgabe zugrunde, ein Verfahren zur Herstellung eines reflexionsmindernden Schichtsystems anzugeben, mit dem verschiedene Oberflächen breitbandig und winkelunabhängig entspiegelt werden können, wobei sich das reflexionsmindernde Schichtsystem insbesondere durch eine weiter verringerte Restreflexion und eine erhöhte Klimastabilität, insbesondere eine gute Beständigkeit gegenüber feuchter Wärme, auszeichnen soll.

Diese Aufgabe wird durch ein Verfahren zur Herstellung eines reflexionsmindernden Schichtsystems gemäß dem unabhängigen Patentanspruch gelöst. Vorteilhafte Ausgestaltungen und Weiterbildungen der Erfindung sind Gegenstand der abhängigen Ansprüche.

Bei dem Verfahren zur Herstellung des reflexionsmindernden Schichtsystems auf einem Substrat wird eine organische Schicht aufgebracht, die gemäß einer bevorzugten Ausgestaltung eine Schichtdicke zwischen 150 nm und 500 nm aufweist. Die organische Schicht kann direkt auf das Substrat oder auf eine zuvor auf das Substrat aufgebrachte Schicht oder Schichtenfolge aufgebracht werden. Insbesondere ist es möglich, dass vor dem Aufbringen der organischen Schicht ein Interferenzschichtsystem aus mehreren dielektrischen Schichten auf das Substrat aufgebracht wird. Weiterhin ist es möglich, dass vor dem Aufbringen der organischen Schicht eine Brechzahlgradientenschicht in dem Substrat oder in einer weiteren auf das Substrat aufgebrachten Schicht erzeugt wird. Dies kann beispielsweise mit einem Plasmaätzprozess erfolgen. Die organische Schicht wird vorzugsweise durch ein Vakuumbeschichtungsverfahren wie zum Beispiel thermisches Aufdampfen oder plasmaionengestützte Abscheidung aufgebracht. Alternativ sind aber auch andere Verfahren zum Aufbringen der organischen Schicht geeignet.

Das Substrat kann beispielsweise ein Glas, einen Kunststoff oder ein Halbleitermaterial wie zum Beispiel Silizium aufweisen. Das Substrat insbesondere ein optisches Element sein, dessen Oberfläche entspiegelt werden soll. Die Oberfläche des Substrats kann eben oder gekrümmt ausgebildet sein.

Gemäß zumindest einer Ausführungsform des Verfahrens wird nachfolgend eine Nanostruktur in der Schicht aus dem organischen Material mit einem Plasmaätzprozess erzeugt.

Die Erzeugung einer Nanostruktur mittels eines Plasmaätzprozesses ist an sich aus der Patentschrift DE 10241708 B4 bekannt.

Nach dem Erzeugen der Nanostruktur wird bei dem Verfahren in einem weiteren Schritt eine Deckschicht auf die Nanostruktur aufgebracht. Die Deckschicht weist vorteilhaft ein anorganisches Material oder eine Silizium-organische Verbindung auf, beispielsweise eine durch Plasmapolymerisation hergestellte Schicht. Die Deckschicht ist bevorzugt mindestens 5 nm dick. Insbesondere ist die Deckschicht derart dünn, dass die Nanostruktur durch die Deckschicht nicht planarisiert wird. Vorteilhaft beträgt die Dicke der Deckschicht zwischen 5 nm und 50 nm, besonders bevorzugt zwischen 15 nm und 35 nm.

Die Deckschicht bedeckt die Nanostruktur vollständig, d.h. sie bildet die Erhebungen und Vertiefungen der Nanostruktur nach. Die Bedeckung kann konform erfolgen. Es genügt jedoch auch, wenn die abgeschiedene Dicke auf den Flanken und in der Tiefe der Nanostruktur wesentlich dünner ist, als auf den Spitzen. Eine solche Bedeckung bildet sich beim Bedampfen oder Besputtern naturgemäß aus.

Die mit der Nanostruktur versehene organische Schicht und die darauf aufgebrachte Deckschicht bilden zusammen eine reflexionsmindernde Struktur aus. Die Brechzahl der reflexionsmindernden Struktur wird bestimmt durch die Anteile des organischen Materials und des Materials der Deckschicht. Das organische Material weist beispielsweise eine Brechzahl 1,6 < n₁ < 1,85 und die Deckschicht eine Brechzahl 1,35 < n₂ < 1,7 auf. Bevorzugt ist die Brechzahl n₁ des organischen Materials größer als 1,7 (z.B. Uracil, Melamin) und die des Deckschichtmaterials kleiner als 1,5 (z.B. SiO₂ mit n₂ = 1,45).

Nach dem Aufbringen der Deckschicht wird bei dem Verfahren vorteilhaft eine Nachbehandlung durchgeführt, wobei das Material der organischen Schicht zumindest teilweise entfernt oder zersetzt wird. Die Nachbehandlung kann insbesondere bewirken, dass das Material der organischen Schicht teilweise in NH3 oder andere gasförmige Bestandteile umgewandelt wird, die aus der organischen Schicht entweichen. Die teilweise Zersetzung oder Entfernung des organischen Materials zeigt sich insbesondere in einer Veränderung des IR-Spektrums des organischen Materials und kann auf diese Weise nachgewiesen werden. Durch die Nachbehandlung wird vorteilhaft erreicht, dass sich die effektive Brechzahl der reflexionsmindernden Struktur, die die nanostrukturierte organische Schicht und die Deckschicht umfasst, vermindert. Insbesondere ist die effektive Brechzahl n_{eff,2} der reflexionsmindernden Struktur nach der Nachbehandlung kleiner ist als die effektive Brechzahl n_{eff,1} vor der Nachbehandlung. Vor der Nachbehandlung weist die reflexionsmindernde Struktur vorzugsweise eine effektive Brechzahl n_{eff,1} im Bereich zwischen 1,15 und 1,25 auf. Nach der Nachbehandlung liegt die effektive Brechzahl n_{eff,2} vorzugsweise im Bereich zwischen 1,03 und 1,23. Die Verringerung der effektiven Brechzahl mittels der Nachbehandlung wird insbesondere dadurch erzielt, dass das Material der organischen Schicht bei der Nachbehandlung zum Teil in Form von gasförmigen Bestandteilen wie zum Beispiel NH3 entweicht und/oder porös wird.

Die mittels der Nachbehandlung erzielte Verringerung der effektiven Brechzahl hat den Vorteil, dass die reflexionsmindernde Wirkung weiter verstärkt wird. Insbesondere kann auf diese Weise erreicht werden, dass sich die Differenz zwischen der effektiven Brechzahl der reflexionsmindernden Struktur und dem Umgebungsmedium, insbesondere Luft, weiter vermindert.

Es ist insbesondere möglich, dass der organische Bestandteil zur Oberfläche der reflexionsmindernden Struktur hin mehr zersetzt und/oder entfernt wird. In diesem Fall bildet sich in der reflexionsmindernden Struktur durch die Nachbehandlung ein Brechzahlgradient aus oder dieser verstärkt sich. An den Spitzen der Nanostruktur befindet sich dann deutlich mehr niedrigbrechendes Deckschichtmaterial und im unteren Bereich der Nanostruktur verbleibt mehr höherbrechendes organisches Material. Dieser Gradientencharakter wirkt sich ebenfalls günstig aus für die breitbandige Entspiegelung.

Gemäß zumindest einer vorteilhaften Ausgestaltung umfasst die Nachbehandlung eine Temperaturbehandlung bei einer Temperatur von mehr als 70 °C. Die Temperaturbehandlung wird vorzugsweise bei einer relativen Luftfeuchte von mehr als 50% durchgeführt. Solche feucht-warmen Bedingungen sind besonders gut dazu geeignet, die organische Schicht zumindest teilweise zu entfernen, zu zersetzen oder umzuwandeln.

Alternativ oder zusätzlich kann die Nachbehandlung eine Plasmabehandlung, eine Behandlung mit UV-Strahlung und/oder eine Behandlung mittels Ionenbeschuss umfassen. Im Fall einer Plasmabehandlung kann diese unter Vakuumbedingungen oder alternativ unter Atmosphärendruck erfolgen. Insbesondere kann ein Mikrowellen-Plasma verwendet werden. Bei der Nachbehandlung mit UV-Strahlung kann insbesondere Strahlung aus dem Nah-UV oder aus dem Vakuum-UV eingesetzt werden.

Gemäß einer bevorzugten Ausgestaltung weist die reflexionsmindernde Struktur eine Schichtdicke zwischen 150 nm und 500 nm auf.

Gemäß zumindest einer Ausführungsform weist die organische Schicht ein stickstoffhaltiges organisches Material mit konjugierter ringförmiger Anordnung auf, das mindestens die Atome Kohlenstoff, Stickstoff und Wasserstoff enthält. Besonders geeignet sind heterozyklische organische Verbindungen mit einem Purin- oder Pyrimidingrundgerüst, insbesondere auch in der Natur vorkommende Stoffe wie Guanin (2-Amino-6-oxo-purin), Xanthin (2,6-Dihydroxypurin) und Uracil (2,4-Pyrimidindion) oder Mischungen dieser Materialien. Weitere geeignete Materialien sind Triazine wie Melamin und andere hochschmelzende Amine oder Polyaminoamide, sowie Aminosäuren und ihre hochschmelzenden Derivate. Das Material der organischen Schicht ist vorzugsweise ein hochschmelzendes Material, wobei hier unter "hochschmelzend" insbesondere ein Material mit einem Schmelzpunkt oberhalb von 100 °C zu verstehen ist.

Für die Deckschicht wird vorteilhaft ein Material ausgewählt, das unter den Bedingungen der Nachbehandlung stabil ist, so dass sich die Struktur der Deckschicht bei der Nachbehandlung im Wesentlichen nicht ändert. Die Deckschicht der Nanostruktur weist vorzugsweise ein Oxid, ein Fluorid oder ein Nitrid auf. Insbesondere kann die Deckschicht ein Siliziumoxid, ein Aluminiumoxid, ein Siliziumnitrid oder Magnesiumfluorid aufweisen.

Bei einer besonders bevorzugten Ausgestaltung ist die Deckschicht zwischen 15 nm und 35 nm dick. Die Deckschicht ist in diesem Fall einerseits dünn genug, dass sie die Nanostruktur konform nachbildet. Andererseits reicht die Dicke der Deckschicht in diesem Bereich aus, dass die Deckschicht die Nachbehandlung im Wesentlichen unverändert übersteht.

Die in der organischen Schicht erzeugte Nanostruktur weist Strukturelemente in Form von Erhebungen und Vertiefungen auf, deren Höhe im Mittel vorzugsweise mehr als 80 nm beträgt, beispielsweise im Bereich von etwa 100 nm bis etwa 200 nm. auf. Es ist vorteilhaft, wenn sich die Nanostruktur nahezu durch die gesamte organische Schicht erstreckt. Auf diese Weise wird ein besonders geringer effektiver Brechungsindex der nanostrukturierten organischen Schicht erzielt. Die Strukturelemente weisen vorzugsweise im Mittel eine Breite von weniger als 40 nm auf. Besonders bevorzugt beträgt die Breite der Strukturelemente zwischen 15 nm und 35 nm.

Die reflexionsmindernde Schichtenfolge zeichnet sich zum einen durch ihre besonders gute reflexionsmindernde Wirkung aufgrund der besonders geringen effektiven Brechzahl der nanostrukturierten organischen Schicht aus. Weiterhin zeichnet sich die reflexionsmindernde Beschichtung durch eine verbesserte Klimastabilität aus. Insbesondere hat die reflexionsmindernde Beschichtung den Vorteil, dass sich ihre optischen Eigenschaften unter klimatischen Bedingungen wie feuchter Wärme nicht wesentlich ändern.

Die Erfindung wird im Folgenden anhand von Ausführungsbeispielen im Zusammenhang mit den Figuren 1 bis 4 näher erläutert.

### Es zeigen:

Figuren 1A bis 1D ein Ausführungsbeispiel des Verfahrens zur Herstellung eines reflexionsmindernden Schichtsystems anhand von schematisch dargestellten Zwischenschritten,
Figur 2 eine grafische Darstellung der Reflexion R in Abhängigkeit von der Wellenlänge λ bei einem Ausführungsbeispiel eines mit dem Verfahren hergestellten reflexionsmindernden Schichtsystems vor der Nachbehandlung und nach der Nachbehandlung,
Figur 3 eine grafische Darstellung eines Infrarotspektrums des reflexionsmindernden Schichtsystems gemäß dem Ausführungsbeispiel der Figur 2 vor der Nachbehandlung und nach der Nachbehandlung, und
Figur 4 eine grafische Darstellung der Reflexion R in Abhängigkeit von der Wellenlänge λ bei einem weiteren Ausführungsbeispiel eines mit dem Verfahren hergestellten reflexionsmindernden Schichtsystems vor der Nachbehandlung und nach der Nachbehandlung.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

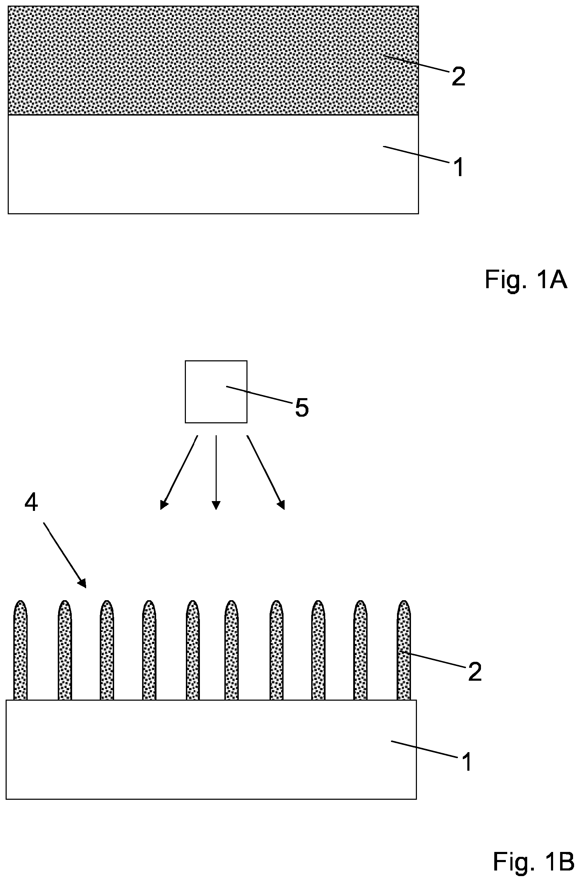

Bei dem in Figur 1A dargestellten Zwischenschritt des Verfahrens ist eine organische Schicht 2 auf ein Substrat 1 aufgebracht wurden. Das Substrat 1 kann eine ebene oder gekrümmte Oberfläche aufweisen und beispielsweise ein Glas, einen Kunststoff oder ein Halbleitermaterial aufweisen. Bei dem Substrat 1 kann es sich insbesondere um ein optisches Element handeln, dessen Oberfläche mit einer reflexionsmindernden Beschichtung versehen werden soll. Beispielsweise kann das Substrat 1 eine Linse wie zum Beispiel ein Brillenglas oder die Oberfläche eines Displays sein.

Die organische Schicht 2 ist vorzugsweise etwa 150 nm bis 500 nm dick. Bei einer Schichtdicke in diesem Bereich ist die organische Schicht 2 dick genug, dass in einem weiteren Verfahrensschritt eine ausreichend tiefe Nanostruktur in ihr erzeugt werden kann.

Das Aufbringen der organischen Schicht 2 erfolgt vorzugsweise mit einem Vakuumbeschichtungsverfahren. Dies hat den Vorteil, dass das gesamte reflexionsmindernde Schichtsystem in einem Vakuumverfahren aufgebracht werden kann. Zum Beispiel kann zum Aufbringen der organischen Schicht 2 ein PVD- oder ein CVD-Verfahren eingesetzt werden. Alternativ ist es aber auch möglich, die organische Schicht 2 mit einem nasschemischen Verfahren aufzubringen.

Die organische Schicht 2 ist aus einem Material gebildet, das bei einer Nachbehandlung in einem späteren Verfahrensschritt zumindest teilweise entfernt, zersetzt und/oder chemisch umgewandelt werden kann. Besonders geeignet sind stickstoffhaltige organische Materialien mit konjugierter ringförmiger Anordnung, die mindestens die Atome Kohlenstoff, Stickstoff und Wasserstoff enthalten. Beispiele für solche Materialien sind heterozyklische organische Verbindungen mit einem Purin- oder Pyrimidingrundgerüst, insbesondere auch in der Natur vorkommende Stoffe wie Guanin (2-Amino-6-oxo-purin), Xanthin (2,6-Dihydroxypurin) und Uracil (2,4-Pyrimidindion) oder Mischungen dieser Materialien. Weitere geeignete Materialien sind Triazine wie Melamin und andere hochschmelzende Amine oder Polyaminoamide, sowie Aminosäuren und ihre hochschmelzenden Derivate. Das Material der organischen Schicht 2 ist insbesondere ein Material mit einem Schmelzpunkt oberhalb von 100 °C.

Bei dem in Figur 1A dargestellten Ausführungsbeispiel ist die organische Schicht 2 unmittelbar auf die Oberfläche des Substrats 1 aufgebracht worden. Es ist alternativ aber auch möglich, das vor dem Aufbringen der organischen Schicht 2 eine oder mehrere weitere Schichten auf das Substrat 1 aufgebracht werden. Die mindestens eine weitere Schicht kann bereits eine reflexionsmindernde Wirkung für das Substrat 1 aufweisen, die mit dem hier beschriebenen Verfahren noch verstärkt werden soll. Beispielsweise kann vor dem Aufbringen der organischen Schicht 2 ein reflexionsminderndes Interferenzschichtsystem auf das Substrat 1 aufgebracht werden.

Nach dem Aufbringen der organischen Schicht 2 wird, wie in Figur 1B dargestellt, ein Plasmaätzprozess durchgeführt, um eine Nanostruktur 4 in der organischen Schicht 2 zu erzeugen. Die Erzeugung der Nanostruktur 4 erfolgt vorzugsweise durch Ionenbeschuss mittels einer Plasma-Ionenquelle 5. Dabei kann beispielsweise ein Argon-Sauerstoff-Plasma verwendet werden. Ein solcher Plasmaätzprozess ist an sich aus den in der Einleitung genannten Druckschriften DE 10241708 B4 oder DE 102008018866 A1 bekannt und wird daher nicht näher erläutert.

Vor der Durchführung des Plasmaätzprozesses kann eine dünne Initialschicht (nicht dargestellt) auf die zu strukturierende organische Schicht 2 aufgebracht werden, die vorzugsweise eine Dicke von nur etwa 2 nm aufweist. Bei der Initialschicht handelt es sich vorzugsweise um eine dünne Oxidschicht, Nitridschicht oder Fluoridschicht. Diese Vorgehensweise ist an sich aus der Druckschrift DE 102008018866 A1 bekannt.

Die Nanostruktur weist eine Vielzahl von Strukturelementen in Form von Erhebungen und Vertiefungen auf, wobei die Erhebungen vorteilhaft mindestens 80 nm hoch sind und eine Breite von vorteilhaft nicht mehr als 40 nm und besonders bevorzugt zwischen 15 nm und 35 nm aufweisen. Die nanostrukturierte organische Schicht 2 weist eine effektive Brechzahl n_{eff,1} auf, die geringer ist als die Brechzahl der organischen Schicht 2 vor der Erzeugung der Nanostruktur. Bevorzugt beträgt die effektive Brechzahl n_{eff,1} der nanostrukturierten organischen Schicht 2 zwischen 1,15 und 1,25.

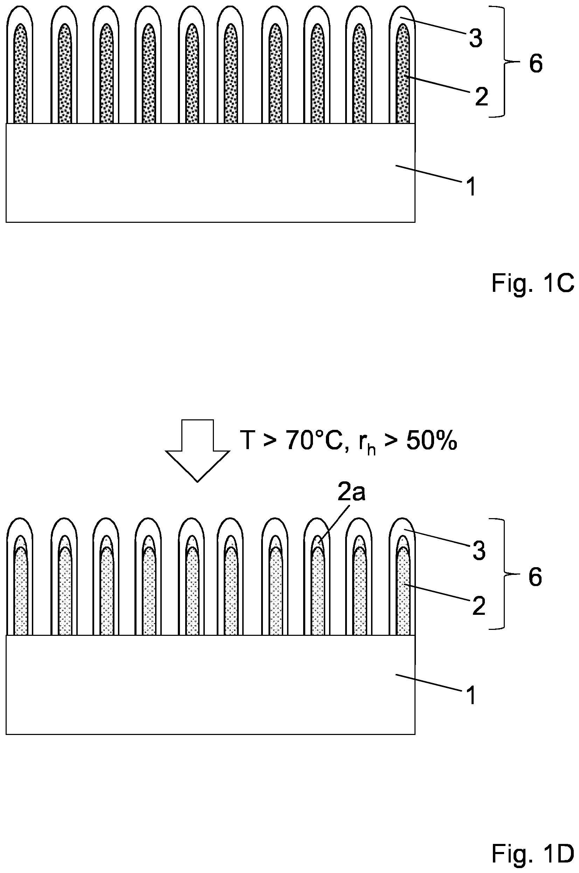

In einem weiteren Verfahrensschritt, der in Figur 1C dargestellt ist, wird eine Deckschicht 3 auf die nanostrukturierte organische Schicht 2 aufgebracht. Die Deckschicht 3 ist vorzugsweise eine anorganische Schicht, insbesondere eine Oxid-, Nitrid- oder Fluorid-Schicht wie beispielsweise Siliziumoxid, Aluminiumoxid, Siliziumnitrid oder Magnesiumfluorid. Alternativ kann die Deckschicht 3 eine Silizium-organische Verbindung aufweisen, beispielsweise ein Plasmapolymer. Ein besonders geeignetes Material für die Deckschicht ist SiO₂.

Die Deckschicht 3 ist vorteilhaft nicht mehr als 50 nm dick. Die Dicke der Deckschicht 3 liegt bevorzugt im Bereich zwischen 5 nm und 35 nm, besonders bevorzugt zwischen 15 nm und 35 nm. Die derart dünne Deckschicht 3 bedeckt die Nanostruktur der organischen Schicht 2 vorteilhaft konform, d.h. sie bildet die Erhebungen und Vertiefungen der organischen Schicht 2 nach. Die Deckschicht 3 bildet zusammen mit der organischen Schicht 2, welche die Nanostruktur 4 aufweist, eine reflexionsmindernde Struktur 6 aus.

In einem weiteren Verfahrensschritt, der in Figur 1D dargestellt ist, erfolgt eine Nachbehandlung der zuvor hergestellten reflexionsmindernden Struktur 6 aus der nanostrukturierten organischen Schicht 2 und der Deckschicht 3. Die Nachbehandlung ist beispielsweise eine Temperaturbehandlung, die vorzugsweise bei einer Temperatur T ≥ 70 °C durchgeführt wird. Bevorzugt erfolgt die Temperaturbehandlung einer hohen relativen Luftfeuchte rₕ ≥ 50 %.

Eine Form der bevorzugten Nachbehandlung ist die Anwendung eines sauerstoff-haltigen Plasmas aus einer Ionenquelle 5, wie sie zuvor schon für den Ätzschritt der organischen Schicht 2 verwendet wurde. Die Behandlung kann dann gleich im selben Vakuumprozess im Anschluss an die Abscheidung der Deckschicht 3 erfolgen.

Die Nachbehandlung bewirkt, dass das Material der organischen Schicht 2 zumindest teilweise entfernt oder zersetzt wird. Insbesondere ist es möglich, dass zumindest ein Teil des organischen Materials der organischen Schicht 2 in gasförmige Bestandteile wie insbesondere NH₃ zersetzt wird, die aus dem Schichtsystem entweichen. Die gasförmigen Bestandteile können insbesondere durch die dünne Deckschicht 3 entweichen. Dadurch, dass die Deckschicht 3 nur eine sehr geringe Dicke aufweist und auf die nanostrukturierte organische Schicht 2 aufgebracht ist, kann die Deckschicht 3 zumindest eine geringe Porösität aufweisen, welche ein Entweichen von gasförmigen Bestandteilen aus der organischen Schicht 2 ermöglicht.

Bei der Nachbehandlung können insbesondere unterhalb der Deckschicht 3 Hohlräume und/oder poröse Bereiche 2a entstehen. Es kann aber auch erreicht werden, dass sich das Material der organischen Schicht 2 insgesamt verändert. Eine Veränderung des Materials der organischen Schicht 2 zeigt sich insbesondere in einer Veränderung der IR-Spektren.

Die Deckschicht 3 aus dem anorganischen Material oder der Silizium-organischen Verbindung wird durch die Nachbehandlung vorteilhaft nicht beeinflusst, so dass sich ihre Eigenschaften, insbesondere die Form und Dicke, bei der Nachbehandlung im Wesentlichen nicht ändern.

Die Nachbehandlung hat den Vorteil, dass sich die effektive Brechzahl der reflexionsmindernden Struktur 6 weiter vermindert. Die effektive Brechzahl n_{eff,2} der reflexionsmindernden Struktur 6 nach der Nachbehandlung ist kleiner als die effektive Brechzahl n_{eff,1} vor der Nachbehandlung. Bevorzugt beträgt die effektive Brechzahl n_{eff,2} der reflexionsmindernden Struktur 6 nach der Nachbehandlung zwischen 1,03 und 1,23. Die besonders geringe effektive Brechzahl nach der Nachbehandlung hat den Vorteil, dass sich die reflexionsmindernde Wirkung weiter verstärkt.

Es ist außerdem möglich, dass der organische Bestandteil zur Oberfläche der reflexionsmindernden Struktur 6 hin stärker zersetzt und/oder entfernt wird und so ein Brechzahlgradient ausgebildet oder verstärkt wird. An den Spitzen der Nanostruktur befindet sich dann deutlich mehr niedrigbrechendes Deckschichtmaterial und im unteren Bereich der Nanostruktur verbleibt mehr höherbrechendes organisches Material. In diesem Fall nimmt die effektive Brechzahl n_{eff,2} in der Richtung vom Substrat 1 zur Oberfläche hin ab. Vorzugsweise beträgt die effektive Brechzahl n_{eff,2} in einem dem Substrat 1 zugewandten Bereich der reflexionsmindernden Struktur zumindest bereichsweise 1,15 < n_{eff,2} < 1,23, und in einem der Deckschicht 3 zugewandten Bereich zumindest bereichsweise 1,03 < n_{eff,2} < 1,1. Durch den auf diese Weise erzeugten Brechzahlgradienten wird eine besonders gute reflexionsmindernde Wirkung erzielt.

Weiterhin hat das auf diese Weise hergestellte reflexionsmindernde Schichtsystem den Vorteil, dass sich die optischen Eigenschaften in einem feucht-warmen Klima nicht mehr wesentlich verändern. Somit zeichnet sich die reflexionsmindernde Beschichtung durch eine verbesserte Klimastabilität aus.

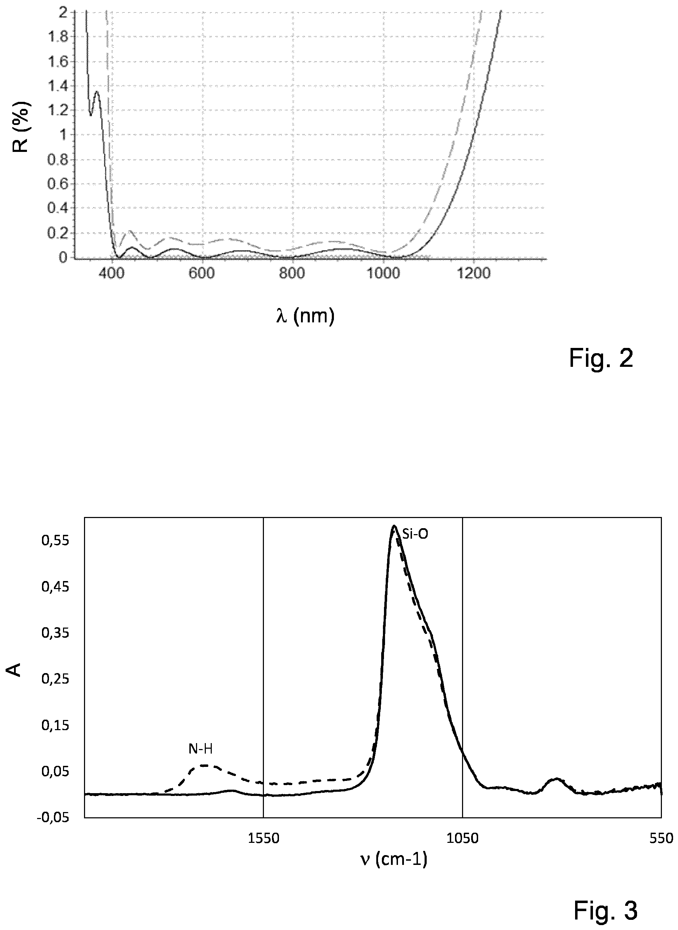

In Figur 2 ist die Reflexion R in Abhängigkeit von der Wellenlänge λ für ein reflexionsminderndes Schichtsystem dargestellt, dass gemäß einem Ausführungsbeispiel des Verfahrens hergestellt wurde. Bei diesem Ausführungsbeispiel wurde ein Glassubstrat vom Typ B270 mit einem Brechungsindex nₛ = 1,53 verwendet. Auf das Glassubstrat ist in einem ersten Schritt ein dielektrisches Interferenzschichtsystem mit acht abwechselnden TiO₂-Schichten und SiO₂-Schichten durch Aufdampfen abgeschieden worden. Das Interferenzschichtsystem besteht bei dem Ausführungsbeispiel ausgehend vom Substrat aus der Schichtenfolge 10 nm TiO₂ / 50 nm SiO₂ / 28 nm TiO₂ / 23 nm SiO₂ / 138 nm TiO₂ / 22 nm SiO₂ / 22 nm TiO₂ / 100 nm SiO₂. Auf dem Interferenzschichtsystem wurde durch Aufdampfen eine 200 nm dicke organische Schicht aus Uracil abgeschieden. In der organischen Uracil-Schicht wurde nachfolgend mit einem Plasmaätzprozess eine Nanostruktur erzeugt, die Strukturelemente mit einer Höhe von etwa 120 nm aufweist. In einem weiteren Schritt wurde eine etwa 30 nm dicke SiO₂-Schicht als Deckschicht auf die Nanostruktur aufgebracht. Die effektive Brechzahl der reflexionsmindernden Struktur aus der organischen Schicht und der Deckschicht beträgt etwa n_{eff,1} = 1,22.

In einem weiteren Schritt wurde eine Nachbehandlung des so hergestellten Schichtsystems durchgeführt, um das reflexionsmindernde Schichtsystem fertig zu stellen. Bei dem Ausführungsbeispiel wurde eine Plasmabehandlung zur Nachbehandlung durchgeführt. Die Nachbehandlung erfolgte in einer Mikrowellen-Plasmaanlage für 10 Minuten in einem O₂-Plasma mit einer Leistung von 400 W und einem Druck von 3*10⁻² mbar.

Die gestrichelte Linie in Figur 2 zeigt die Reflexion vor der Nachbehandlung und die durchgezogene Linie die Reflexion nach der Nachbehandlung. Es zeigt sich, dass sich die Restreflexion insbesondere im Spektralbereich zwischen 400 nm und 1000 nm durch die Nachbehandlung vorteilhaft weiter vermindert. Die nanostrukturierte organische Schicht weist nach der Nachbehandlung eine effektive Brechzahl von nur noch n_{eff,2} = 1,15 auf. Es hat sich weiterhin herausgestellt, dass sich die optischen Eigenschaften des auf diese Weise hergestellten reflexionsmindernden Schichtsystems bei Lagerung für einen Zeitraum von 48 Stunden in einem feucht-warmen Klima (85% relative Luftfeuchte, T = 80°C) oder bei einer sehr hohen Temperatur (T =110 °C) nicht ändern.

Figur 3 zeigt gemessene FTIR-Spektren des reflexionsmindernden Schichtsystems gemäß dem Ausführungsbeispiel der Figur 2 vor und nach der Plasma-Nachbehandlung. Dargestellt ist die Absorption A (in willkürlichen Einheiten) in Abhängigkeit der Wellenzahl v. Das Infrarotspektrum vor der Nachbehandlung (gestrichelte Linie) zeigt deutliche Signale des organischen Materials (insbesondere die N-H-Bande) zusammen mit dem ausgeprägten Signal des SiO2-Anteils (Si-O-Bande). Dagegen zeigt das Infrarotspektrum der im Mikrowellenplasma nachbehandelten reflexionsmindernden Struktur (durchgezogene Linie) kaum noch Banden des organischen Bestandteils.

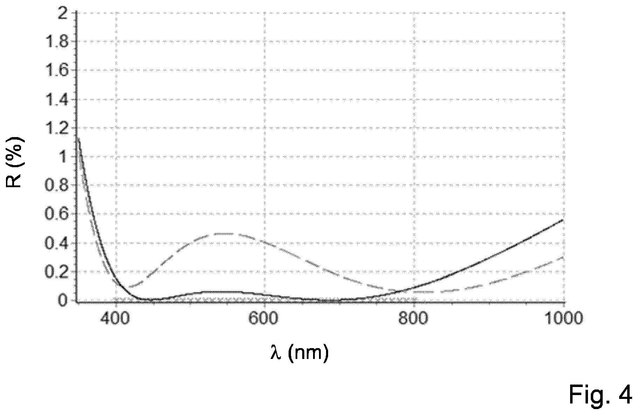

In Figur 4 ist die Reflexion R in Abhängigkeit von der Wellenlänge λ für ein reflexionsminderndes Schichtsystem dargestellt, dass gemäß einem weiteren Ausführungsbeispiel des Verfahrens hergestellt wurde. Bei diesem Ausführungsbeispiel wurde ein Kunststoffsubstrat aus Zeonex mit einem Brechungsindex nₛ = 1,53 verwendet. In dem Kunststoffsubstrat ist in einem ersten Schritt durch einen ersten Plasmaätzprozess eine erste Nanostruktur erzeugt worden, die eine Tiefe von 100 nm und eine effektive Brechzahl von n = 1,35 aufweist.

Auf die in dem Kunststoffsubstrat erzeugte erste Nanostruktur wurde durch Aufdampfen eine 220 nm dicke organische Schicht aus Xanthin abgeschieden. In der organischen Xanthin-Schicht wurde nachfolgend mit einem zweiten Plasmaätzprozess eine zweite Nanostruktur erzeugt, die Strukturelemente mit einer Höhe von etwa 120 nm aufweist. In einem weiteren Schritt wurde eine etwa 20 nm dicke SiO₂-Schicht als Deckschicht auf die zweite Nanostruktur aufgebracht. Die effektive Brechzahl der zweiten Nanostruktur mit der Deckschicht beträgt etwa n_{eff,1} = 1,18.

In einem weiteren Schritt wurde eine Nachbehandlung des so hergestellten Schichtsystems durchgeführt, um das reflexionsmindernde Schichtsystem fertig zu stellen. Bei dem Ausführungsbeispiel wurde eine Plasmabehandlung zur Nachbehandlung durchgeführt. Die Nachbehandlung erfolgte direkt in der Beschichtungsanlage (Typ Leybold SyrusPro mit der darin befindlichen Plasma-Ionenquelle vom Typ APS). Die Plasmabehandlung wurde mit einer Mischung bestehend aus 35% Argon und 65% Sauerstoff, einer maximalen Ionenenergie von 100eV (Bias-Spannung 100V) für 10 Minuten bei einem Druck von 3*10-4 mbar durchgeführt.

Die gestrichelte Linie in Figur 3 zeigt die Reflexion vor der Nachbehandlung und die durchgezogene Linie die Reflexion nach der Nachbehandlung. Es zeigt sich, dass sich die Restreflexion insbesondere im Spektralbereich zwischen etwa 400 nm und etwa 800 nm durch die Nachbehandlung vorteilhaft weiter vermindert. Die reflexionsmindernde Struktur weist nach der Nachbehandlung eine effektive Brechzahl von nur noch n_{eff,2} = 1,13 auf. Es hat sich weiterhin herausgestellt, dass sich die optischen Eigenschaften des auf diese Weise hergestellten reflexionsmindernden Schichtsystems bei Lagerung für einen Zeitraum von 48 Stunden in einem feucht-warmen Klima (85% relative Luftfeuchte, T = 50 °C) oder bei einer sehr hohen Temperatur (T = 100 °C) nicht weiter ändern. Die Erfindung ist nicht durch die Beschreibung anhand der Ausführungsbeispiele beschränkt.

### Bezugszeichenliste

- 1: Substrat
- 2: organische Schicht
- 3: Deckschicht
- 4: Nanostruktur
- 5: Plasmaionenquelle
- 6: reflexionsmindernde Nanostruktur

## Patentansprüche

1. Verfahren zur Herstellung eines reflexionsmindernden Schichtsystems auf einem Substrat (1), umfassend die Schritte:
- Abscheidung einer organischen Schicht (2),
- Erzeugung einer Nanostruktur (4) in der organischen Schicht (2) durch einen Plasmaätzprozess,
- Aufbringen einer Deckschicht (3) auf die Nanostruktur (4), wobei die mit der Nanostruktur (4) versehene organische Schicht (2) und die Deckschicht (3) gemeinsam eine reflexionsmindernde Struktur (6) bilden, wobei die Deckschicht (3) ein anorganisches Material oder eine Silizium-organische Verbindung aufweist, und wobei die Deckschicht (3) mindestens 5 nm dick ist, und
- Durchführung einer Nachbehandlung nach dem Aufbringen der Deckschicht (3), wobei das Material der organischen Schicht (2) zumindest teilweise entfernt oder zersetzt wird, und wobei die effektive Brechzahl n_{eff,2} der reflexionsmindernden Struktur (6) nach der Nachbehandlung kleiner ist als die effektive Brechzahl n_{eff,1} der reflexionsmindernden Struktur (6) vor der Nachbehandlung.

2. Verfahren nach Anspruch 1,
wobei bei der Nachbehandlung unterhalb der Deckschicht (3) Hohlräume und/oder poröse Bereiche (2a) entstehen.

3. Verfahren nach einem der vorhergehenden Ansprüche, wobei für die effektive Brechzahl n_{eff,1} der reflexionsmindernden Struktur (6) vor der Nachbehandlung gilt: 1,15 < n_{eff,1} < 1,25.

4. Verfahren nach einem der vorhergehenden Ansprüche, wobei für die effektive Brechzahl n_{eff,2} der reflexionsmindernden Struktur (6) nach der Nachbehandlung gilt: 1,03 < n_{eff,2} < 1,23.

5. Verfahren nach einem der vorhergehenden Ansprüche, wobei die reflexionsmindernde Struktur (6) nach der Nachbehandlung einen Brechzahlgradienten aufweist, wobei die effektive Brechzahl n_{eff,2} in einem dem Substrat (1) zugewandten Bereich der reflexionsmindernden Struktur (6) zumindest bereichsweise 1,15 < n_{eff,2} < 1,23 beträgt, und in einem der Deckschicht (3) zugewandten Bereich zumindest bereichsweise 1,03 < n_{eff,2} < 1,1 beträgt.

6. Verfahren nach einem der vorhergehenden Ansprüche, wobei die Nachbehandlung eine Temperaturbehandlung bei einer Temperatur von mehr als 70 °C umfasst.

7. Verfahren nach Anspruch 6,
wobei die Temperaturbehandlung bei einer relativen Luftfeuchte von mehr als 50% erfolgt.

8. Verfahren nach einem der vorhergehenden Ansprüche, wobei die Nachbehandlung eine Plasmabehandlung, eine Behandlung mit UV-Strahlung oder eine Behandlung mittels Ionenbeschuss umfasst.

9. Verfahren nach einem der vorhergehenden Ansprüche, wobei die reflexionsmindernde Struktur (6) zwischen 150 nm und 500 nm dick ist.

10. Verfahren nach einem der vorhergehenden Ansprüche, wobei die organische Schicht (2) ein stickstoffhaltiges organisches Material mit konjugierter ringförmiger Anordnung aufweist, das mindestens die Atome Kohlenstoff, Stickstoff und Wasserstoff enthält.

11. Verfahren nach einem der vorhergehenden Ansprüche, wobei die organische Schicht (2) mindestens eines der folgenden Materialien enthält:
- eine heterozyklische organische Verbindung mit einem Purin- oder Pyrimidingrundgerüst, insbesondere Guanin (2-Amino-6-oxo-purin), Xanthin (2,6-Dihydroxypurin) und Uracil (2,4-Pyrimidindion) oder Mischungen dieser Materialien;
- ein Triazin, insbesondere Melamin;
- ein Amin oder Polyaminoamid;
- eine Aminosäure oder ein Derivat einer Aminosäure, mit einem Schmelzpunkt > 100°C.

12. Verfahren nach einem der vorhergehenden Ansprüche, wobei die Deckschicht (3) ein Oxid, ein Fluorid oder ein Nitrid aufweist.

13. Verfahren nach einem der vorhergehenden Ansprüche, wobei die Deckschicht (3) zwischen 15 nm und 35 nm dick ist.

14. Verfahren nach einem der vorhergehenden Ansprüche, wobei die reflexionsmindernde Struktur (6) Strukturelemente in Form von Erhebungen und Vertiefungen aufweist, deren Höhe im Mittel mehr als 80 nm beträgt.

15. Verfahren nach einem der vorhergehenden Ansprüche, wobei die reflexionsmindernde Struktur (6) Strukturelemente in Form von Erhebungen und Vertiefungen aufweist, deren Breite im Mittel weniger als 40 nm beträgt.

## Claims

1. A method for producing a reflection-reducing layer system on a substrate (1) comprising the steps of:
- depositing an organic layer (2),
- generating a nanostructure (4) in the organic layer (2) by a plasma etching process,
- applying a cover layer (3) to the nanostructure (4), wherein the organic layer (2) provided with the nanostructure (4) and the cover layer (3) together form a reflection-reducing structure (6), wherein the cover layer (3) comprises an inorganic material or an organosilicon compound and wherein the cover layer (3) is at least 5 nm thick, and
- carrying out a post-treatment after the application of the cover layer (3), wherein the material of the organic layer (2) is at least partially removed or decomposed, and wherein the effective refractive index n_{eff,2} of the reflection-reducing structure (6) after the post-treatment is smaller than the effective refractive index n_{eff,1} of the reflection-reducing structure (6) before the post-treatment.

2. The method according to claim 1,
wherein cavities and/or porous regions (2a) are formed below the cover layer (3) during the post-treatment.

3. The method according to any of the preceding claims, wherein the effective refractive index n_{eff,1} of the reflection-reducing structure (6) before the post-treatment is: 1.15 < n_{eff,1} < 1.25.

4. The method according to any of the preceding claims, wherein the effective refractive index n_{eff,2} of the reflection-reducing structure (6) after the post-treatment is: 1.03 < n_{eff,2} < 1.23.

5. The method according to any of the preceding claims, wherein the reflection-reducing structure (6) has a refractive index gradient after the post-treatment, wherein the effective refractive index n_{eff,2} in a region of the reflection-reducing structure (6) facing the substrate (1) is at least regionally 1.15 < n_{eff,2} < 1.23, and 1.03 < n_{eff,2} < 1.1 in a region facing the cover layer (3) at least regionally.

6. The method according to any of the preceding claims, wherein the post-treatment comprises a temperature treatment at a temperature greater than 70°C.

7. The method according to claim 6,
wherein the temperature treatment is carried out at a relative humidity of more than 50%.

8. The method according to any of the preceding claims, wherein the post-treatment comprises a plasma treatment, a treatment with UV radiation or a treatment by ion bombardment.

9. The method according to any of the preceding claims, wherein the reflection-reducing structure (6) is between 150 nm and 500 nm thick.

10. The method according to any of the preceding claims, wherein the organic layer (2) comprises a nitrogen-containing organic material having a conjugated ring-shaped structure containing at least the atoms carbon, nitrogen and hydrogen.

11. The method according to any of the preceding claims, wherein the organic layer (2) contains at least one of the following materials:
- a heterocyclic organic compound having a purine or pyrimidine backbone, in particular guanine (2-amino-6-oxo-purine), xanthine (2,6-dihydroxypurine) and uracil (2,4-pyrimidinedione) or mixtures of these materials;
- a triazine, in particular melamine;
- an amine or polyaminoamide;
- an amino acid or a derivative of an amino acid, having a melting point > 100°C.

12. The method according to any of the preceding claims, wherein the cover layer (3) comprises an oxide, a fluoride or a nitride.

13. The method according to any of the preceding claims, wherein the cover layer (3) is between 15 nm and 35 nm thick.

14. The method according to any of the preceding claims, wherein the reflection-reducing structure (6) comprises structural elements in the form of elevations and depressions having an average height of more than 80 nm.

15. The method according to any of the preceding claims, wherein the reflection-reducing structure (6) comprises structural elements in the form of elevations and depressions having an average width of less than 40 nm.

## Revendications

1. Un procédé de production d'un système de couches réduisant les réflexions sur un substrat (1), comprenant les étapes suivantes :
- Dépôt d'une couche organique (2),
- Création d'une nanostructure (4) dans la couche organique (2) par un processus de gravure au plasma,
- Application d'une couche de couverture (3) sur la nanostructure (4), la couche organique (2) pourvue de la nanostructure (4) et la couche de couverture (3) formant ensemble une structure (6) réduisant les réflexions, la couche de couverture (3) comprenant un matériau inorganique ou un composé organique de silicium, et la couche de couverture (3) ayant une épaisseur d'au moins 5 nm, et
- Réalisation d'un traitement ultérieur après l'application de la couche de couverture (3), le matériau de la couche organique (2) étant au moins partiellement éliminé ou décomposé, et l'indice de réfraction effectif n_{eff,2} de la structure réduisant les réflexions (6) après le traitement ultérieur étant inférieur à l'indice de réfraction effectif n_{eff,1} de la structure réduisant les réflexions (6) avant le traitement ultérieur.

2. Le procédé selon la revendication 1,
dans lequel, lors du traitement ultérieur, des cavités et/ou des zones poreuses (2a) apparaissent sous la couche de couverture (3).

3. Le procédé selon l'une des revendications précédentes, où, dans lequel on a pour l'indice de réfraction effectif n_{eff,1} de la structure réduisant les réflexions (6) avant le traitement ultérieur : 1,15 < n_{eff,1} < 1,25.

4. Le procédé selon l'une quelconque des revendications précédentes,
dans lequel on a pour l'indice de réfraction effectif n_{eff,2} de la structure réduisant les réflexions (6) après le traitement ultérieur : 1,03 < n_{eff,2} < 1,23.

5. Le procédé selon l'une quelconque des revendications précédentes,
dans lequel la structure réduisant les réflexions (6) après le traitement ultérieur présente un gradient d'indice de réfraction, l'indice de réfraction effectif n_{eff,2} dans une zone de la structure réduisant les réflexions (6) orientée vers le substrat (1) étant au moins par endroits de 1,15 < n_{eff,2} < 1,23, et dans une zone orientée vers la couche de couverture (3) étant au moins par endroits de 1,03 < n_{eff,2} < 1,1.

6. Le procédé selon l'une quelconque des revendications précédentes,
dans lequel le traitement ultérieur comprend un traitement thermique à une température supérieure à 70 °C.

7. Le procédé selon la revendication 6,
dans lequel le traitement thermique est effectué à une humidité relative de l'air supérieure à 50 %.

8. Le procédé selon l'une quelconque des revendications précédentes,
dans lequel le traitement ultérieur comprend un traitement par plasma, un traitement par rayonnement UV ou un traitement par bombardement ionique.

9. Le procédé selon l'une quelconque des revendications précédentes,
dans lequel la structure réduisant les réflexions (6) a une épaisseur comprise entre 150 nm et 500 nm.

10. Le procédé selon l'une quelconque des revendications précédentes,
dans lequel la couche organique (2) comprend un matériau organique contenant de l'azote avec un arrangement cyclique conjugué contenant au moins les atomes de carbone, d'azote et d'hydrogène.

11. Le procédé selon l'une quelconque des revendications précédentes,
dans lequel la couche organique (2) contient au moins un des matériaux suivants :
- un composé organique hétérocyclique ayant un squelette de purine ou de pyrimidine, en particulier de la guanine (2-amino-6-oxo-purine), de la xanthine (2,6-dihydroxypurine) et de l'uracile (2,4-pyrimidinedione), ou des mélanges de ces matériaux ;
- une triazine, en particulier une mélamine ;
- une amine ou un polyaminoamide ;
- un aminoacide ou un dérivé d'aminoacide, ayant un point de fusion > 100°C.

12. Le procédé selon l'une quelconque des revendications précédentes,
dans lequel la couche de couverture (3) comprend un oxyde, un fluorure ou un nitrure.

13. Le procédé selon l'une quelconque des revendications précédentes,
dans lequel la couche de recouvrement (3) a une épaisseur comprise entre 15 nm et 35 nm.

14. Le procédé selon l'une quelconque des revendications précédentes,
dans lequel la structure réduisant les réflexions (6) présente des éléments de structure sous forme de bosses et de creux dont la hauteur moyenne est supérieure à 80 nm.

15. Le procédé selon l'une des revendications précédentes, dans lequel la structure réduisant les réflexions (6) présente des éléments de structure sous forme de bosses et de creux dont la largeur est en moyenne inférieure à 40 nm.
